# EUROPEAN PATENT APPLICATION

(11) **EP 4 329 454 A1**
(43) Date of publication of application: **28.02.2024**
(21) Application number: 22839611.5
(22) Date of filing: 01.08.2022
(51) Int. Cl.: H10B 12/00

(54) **SEMICONDUCTOR STRUCTURE AND FORMING METHOD THEREFOR**

(30) Priority: 21.06.2022 CN 202210704100
(71) Applicant: Changxin Memory Technologies, Inc., Hefei, Anhui 230601 (CN)
(72) Inventor: SHAO, Guangsu, Hefei City, Anhui 23061 (CN); XIAO, Deyuan, Hefei City, Anhui 23061 (CN); QIU, Yunsong, Hefei City, Anhui 23061 (CN); BAI, Weiping, Hefei City, Anhui 23061 (CN); SU, Xingsong, Hefei City, Anhui 23061 (CN); YU, Mengkang, Hefei City, Anhui 23061 (CN); HUANG, Juan Juan, Hefei City, Anhui 23061 (CN)
(74) Representative: Lavoix
(86) International application number: PCT/CN2022/109461
(87) International publication number: WO 2023/245816

(57) **Abstract**

The present application relates to a semiconductor structure and a method for forming a semiconductor structure. The semiconductor structure includes a plurality of memory cells located on a substrate. Each of the plurality of memory cells includes a transistor and a capacitor. The capacitor is electrically connected to the transistor. The capacitor includes a body portion, and at least one extension portion located on a side surface of the body portion, and the at least one extension portion is electrically connected to the body portion. The present application increases the capacitance of the capacitor and increases the storage capacity of the semiconductor structure.

## Description

### CROSS-REFERENCE TO RELATED APPLICATION

This application claims priority to Chinese Patent Application No. 202210704100.7, filed on June 21, 2022 and entitled "SEMICONDUCTOR STRUCTURE AND METHOD FOR FORMING SEMICONDUCTOR STRUCTURE", the contents of which are hereby incorporated by reference in its entirety.

### TECHNICAL FIELD

The present application relates to the technical field of semiconductor manufacturing, and more particularly, to a semiconductor structure and a method for forming a semiconductor structure.

### BACKGROUND

A Dynamic Random Access Memory, DRAM is a semiconductor device commonly used in electronic devices such as computers, and is composed of a plurality of memory cells. Each of the plurality of memory cells typically includes a transistor and a capacitor. A gate electrode of the transistor is electrically connected to a word line, a source electrode of the transistor is electrically connected to a bit line, and a drain electrode of the transistor is electrically connected to the capacitor. A word line voltage on the word line can control the turn-on and turn-off of the transistor, so that data information stored in the capacitor can be read or written into the capacitor through the bit line. With the continuous development of a semiconductor manufacturing technology, various fields have increasingly demanded the storage capacity of semiconductor structures such as the DRAM. However, a conventional semiconductor structure such as the DRAM has a low capacitance of the capacitor due to the structural limitation thereof, thereby limiting the increase of the storage capacity of the semiconductor structure. Therefore, how to increase the capacitance of a semiconductor structure so as to improve the storage capacity of the semiconductor structure is a technical problem to be solved urgently at present.

### SUMMARY

Some embodiments of the present application provide a semiconductor structure and a method for forming a semiconductor structure, intended to solve the problem of low capacitance of the semiconductor structure so as to increase the storage capacity of the semiconductor structure.

According to some embodiments, the present application provides a semiconductor structure. The semiconductor structure includes a plurality of memory cells located on a substrate. Each of the plurality of memory cells includes a transistor and a capacitor. The capacitor is electrically connected to the transistor. The capacitor includes a body portion, and at least one extension portion located on a side surface of the body portion, and the at least one extension portion is electrically connected to the body portion.

In some embodiments, the capacitor includes a plurality of extension portions, and the plurality of extension portions are distributed at least on one side of the body portion.

In some embodiments, the capacitor includes a plurality of extension portions, and the plurality of extension portions are distributed on two opposite sides of the body portion at least along a first direction. The first direction is a direction parallel to a top surface of the substrate.

In some embodiments, the transistor includes: source electrode/drain electrode, one of the source electrode/drain electrode being electrically connected to the capacitor; a channel layer located between the source electrode and the drain electrode of the source electrode/drain electrode; and a gate electrode, the channel layer surrounding at least a portion of the gate electrode.

In some embodiments, a width of a projection of the extension portion on the substrate along a first direction is greater than a width of a projection of the body portion on the substrate along the first direction, and the body portion is electrically connected to the transistor.

In some embodiments, the capacitor includes: a lower electrode layer, including a first sub-lower electrode layer, and a second sub-lower electrode layer intersecting with the first sub-lower electrode layer, the lower electrode layer being in contact with the transistor and being electrically connected to the transistor; a dielectric layer covering an inner surface of the lower electrode layer; and an upper electrode layer covering a surface of the dielectric layer. The first sub-lower electrode layer defines a position of the body portion, and the second sub-lower electrode layer defines a position of the extension portion.

In some embodiments, the capacitor includes: a lower electrode layer, including a first sub-lower electrode layer, and a second sub-lower electrode layer intersecting with the first sub-lower electrode layer, the lower electrode layer being in contact with the transistor and being electrically connected to the transistor; a dielectric layer continuously wrapping a surface of the lower electrode layer; and an upper electrode layer continuously wrapping a surface of the dielectric layer. The first sub-lower electrode layer defines a position of the body portion, and the second sub-lower electrode layer defines a position of the extension portion.

In some embodiments, the transistor is located below the capacitor, and a first isolation layer is arranged between the transistor and the capacitor. The body portion of the capacitor penetrates through the first isolation layer to be electrically connected to the transistor.

In some embodiments, the plurality of memory cells are arranged in an array along a first direction and a second direction, the first direction and the second direction are directions parallel to a top surface of the substrate, and the first direction intersects with the second direction. The semiconductor structure further includes: a plurality of word lines extending along the second direction, each of the plurality of word lines being electrically connected to respective ones of the plurality of memory cells arranged in the second direction; and a plurality of bit lines extending along the first direction, the plurality of bit lines being located below the plurality of word lines, and each of the plurality of bit lines being electrically connected to respective ones of the plurality of memory cells arranged in the first direction.

In some embodiments, the plurality of memory cells are stacked onto one another along a third direction, where the third direction is a direction perpendicular to a top surface of the substrate.

According to other embodiments, the present application also provides a method for forming a semiconductor structure, including the following operations: a substrate is provided; and a plurality of memory cells are formed on the substrate. The operation that the plurality of memory cells are formed includes the following operations: a plurality of transistors are formed on the substrate; and a plurality of capacitors are formed, where each of the plurality of capacitors is electrically connected to a respective one of the plurality of transistors, each of the plurality of capacitors includes a body portion, and an extension portion located on a side surface of the body portion, and the extension portion is electrically connected to the body portion.

In some embodiments, before the plurality of transistors are formed on the substrate, the method further includes the following operations. A plurality of bit lines spaced apart from each other along a second direction are formed, where each of the plurality of bit lines extends along a first direction, the first direction and the second direction are directions parallel to a top surface of the substrate, and the first direction and the second direction intersect with each other. A third isolation layer covering the plurality of bit lines are formed.

In some embodiments, the operation that the plurality of transistors are formed on the substrate includes the following operations. A plurality of transistor areas spaced apart from each other along the second direction are defined above the substrate. A gate electrode is formed in each of the plurality of transistor areas, and a word line extending along the second direction is formed, the word line being connected to the plurality of gate electrodes. A channel layer extending along the second direction is formed above the word line, the channel layer continuously covering the plurality of transistor areas. A source electrode and a drain electrode which cover at least a surface of the channel layer are formed in each of the plurality of transistor areas, where the channel layer is located at least between the source electrode and the drain electrode.

In some embodiments, the operation that the plurality of capacitors are formed includes the following operations. A first isolation layer covering the plurality of transistors is formed. A second isolation layer is formed above the first isolation layer. A plurality of capacitor areas spaced apart from each other along the second direction are defined above the substrate, where the plurality of capacitors are formed in the plurality of capacitor areas. A plurality of sub-trenches and a plurality of communication trenches are formed in each of the plurality of capacitor areas, where the plurality of sub-trenches penetrating through the second isolation layer along a third direction, and the plurality of communication trenches penetrating through the second isolation layer and the first isolation layer along the third direction, where each of the plurality of communication trenches in each of the plurality of capacitor areas communicates with the plurality of sub-trenches in the same capacitor area, and the third direction is a direction perpendicular to the top surface of the substrate. The extension portion is formed in each of the plurality of sub-trenches, and the body portion is formed in each of the plurality of communication trenches.

In some embodiments, the operation that the extension portion is formed in each of the plurality of sub-trenches, and the body portion is formed in each of the plurality of communication trenches includes the following operations. A lower electrode layer continuously covering inner walls of the plurality of sub-trenches and inner walls of the plurality of communication trenches is formed. A dielectric layer covering a surface of the lower electrode layer and a top surface of the second isolation layer is formed. An upper electrode layer covering a surface of the dielectric layer is formed, where the extension portion includes the lower electrode layer, the dielectric layer and the upper electrode layer which are located in each of the plurality of sub-trenches, and the body portion includes the lower electrode layer, the dielectric layer and the upper electrode layer which are located in each of the plurality of communication trenches.

In some embodiments, the operation that the extension portion is formed in each of the plurality of sub-trenches, and the body portion is formed in each of the plurality of communication trenches includes the following operations. A lower electrode layer continuously covering inner walls of the plurality of sub-trenches and inner walls of the plurality of communication trenches is formed. The second isolation layer is removed. A dielectric layer covering a surface of the lower electrode layer is formed. An upper electrode layer covering a surface of the dielectric layer is formed. The lower electrode layer, the dielectric layer and the upper electrode layer which are located in each of the plurality of sub-trenches constitute the extension portion, and the lower electrode layer, the dielectric layer and the upper electrode layer which are located in each of the plurality of communication trenches constitute the body portion.

In some embodiments, the method further includes the following operation. The plurality of memory cells stacked onto one another along a third direction are successively formed above the substrate, where the third direction is a direction perpendicular to a top surface of the substrate.

Some embodiments of the present application provide a semiconductor structure and a method for forming a semiconductor structure. A capacitor structure is disposed above a transistor structure, and the capacitor structure includes a transistor and a capacitor electrically connected to the transistor. Each of the plurality of capacitors includes an extension portion and a body portion intersecting with the extension, which may increase the dimension of the plurality of capacitors, thereby achieving the effect of increasing the capacitance of each of the plurality of capacitors to increase the storage capacity of the semiconductor structure. In addition, each of the plurality of capacitors including the body portion and the extension portion in the present application is located above the transistor structure, so that a three-dimensional space above the substrate can be fully utilized, the occupation of the surface area of the substrate can be reduced, and the space utilization rate inside the semiconductor structure can be improved, thereby contributing to further controlling the dimension of the semiconductor structure and expanding the application field of the semiconductor structure. In the embodiments of the present application, the dimension of a single layer can be increased, and multi-layer stacking of three-dimensional semiconductor structures can also be achieved, thereby reducing the process difficulty and increasing the storage density of the semiconductor structure.

### BRIEF DESCRIPTION OF THE DRAWINGS

FIG. 1 is a schematic cross-sectional view of a semiconductor structure in a specific implementation of the present application.
FIG. 2 is a schematic partial top view of a capacitor structure in an embodiment of a specific implementation of the present application.
FIG. 3 is a schematic partial top view of a capacitor structure in another embodiment of a specific implementation of the present application.
FIG. 4 is a flowchart of a method for forming a semiconductor structure in a specific implementation of the present application.
FIG. 5A to FIG. 5N are schematic views of main structures in a process of forming a semiconductor structure according to a specific implementation of the present application.
FIG. 6A to FIG. 6G are schematic views of various capacitors in a specific implementation of the present application.

### DETAILED DESCRIPTION

The specific implementations of a semiconductor structure and a method for forming a semiconductor structure provided in the present application will be described in detail below with reference to the drawings.

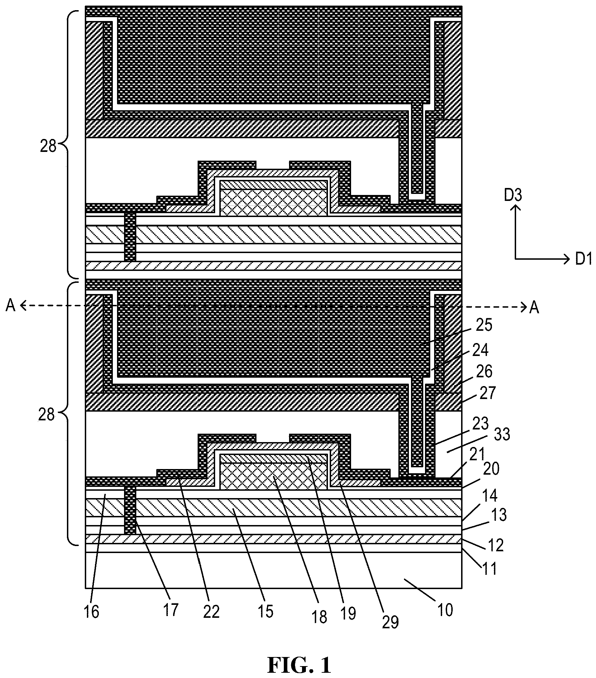

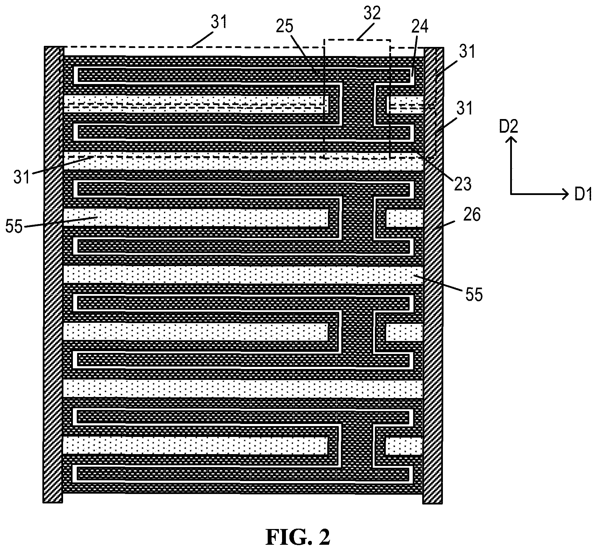

This specific implementation provides a semiconductor structure. FIG. 1 is a schematic cross-sectional view of a semiconductor structure in a specific implementation of the present application. FIG. 2 is a schematic partial top view of a capacitor structure in an embodiment of a specific implementation of the present application. The semiconductor structure in this specific implementation may be, but is not limited to, a DRAM. As shown in FIG. 1 and FIG. 2, the semiconductor structure includes a plurality of memory cells 28 located on a substrate 10. Each of the plurality of memory cells 28 includes:
a transistor; and
a capacitor electrically connected to the transistor, where the capacitor includes a body portion 32, and at least one extension portion 31 located on a side surface of the body portion 32, and the at least one extension portion 31 is electrically connected to the body portion.

Specifically, the substrate 10 may be, but is not limited to, a silicon substrate. This specific implementation will be described with reference to the substrate 10 being a silicon substrate. In other examples, the substrate 10 may be a semiconductor substrate such as gallium nitride, gallium arsenide, gallium carbide, silicon carbide, or SOI. In an embodiment, each of the plurality of memory cells 28 includes a transistor structure. The transistor structure is located above the substrate 10 and includes at least a plurality of said transistors spaced apart from each other along a first direction D1. The first direction D1 is a direction parallel to a top surface of the substrate 10. Each of the plurality of memory cells 28 further includes a capacitor structure. The capacitor structure includes a plurality of said capacitors spaced apart from each other along the first direction D1. The capacitor structure is located above the transistor structure along a third direction D3, where the third direction D3 is a direction perpendicular to the top surface of the substrate 10. In some embodiments of the present application, the plurality of memory cells 28 may be arranged in each of the first direction D1 and a second direction D2, which may increase the dimension of a single layer; and multi-layers are stacked onto one another in the third direction D3, which may realize a three-dimensional semiconductor structure, thereby reducing the process difficulty and improving the storage density of the semiconductor structure. The top surface of the substrate 10 refers to a surface of the substrate 10 facing toward the plurality of memory cells. The capacitor structure includes the plurality of capacitors spaced apart from each other along the first direction D1, and each of the plurality of capacitors is electrically connected to a respective one of the plurality of transistors to form a 1T1C structure. Each of the plurality of capacitors includes the body portion 32 and the at least one extension portion 31 located on a side surface of the body portion 32. A corner structure is formed by the intersection of the body portion 32 and the at least one extension portion 31, which may increase the dimension of each of the plurality of capacitors and thus increase the capacitance of each of the plurality of capacitors, thereby achieving the effect of increasing the storage capacity of the semiconductor structure.

Specifically, the at least one extension portion 31 includes a first sub-lower electrode layer, a first sub-dielectric layer covering a surface of the first sub-lower electrode layer, and a first sub-upper electrode layer covering a surface of the first sub-dielectric layer. The body portion includes a second sub-lower electrode layer, a second sub-dielectric layer covering a surface of the second sub-lower electrode layer, and a second sub-upper electrode layer covering a surface of the second sub-dielectric layer. The first sub-lower electrode layer and the second sub-lower electrode layer intersect with each other and are electrically connected to each other, and the first sub-upper electrode layer and the second sub-upper electrode layer intersect with each other and are electrically connected to each other. The first sub-lower electrode layer and the second sub-lower electrode layer collectively serve as a lower electrode layer of the capacitor, the first sub-dielectric layer and the second sub-dielectric layer collectively serve as a dielectric layer of the capacitor, and the first sub-upper electrode layer and the second sub-upper electrode layer collectively serve as an upper electrode layer of the capacitor. The surface area of the lower electrode layer and the surface area of the upper electrode layer are increased by forming a bending lower electrode layer and a bending upper electrode layer, thereby increasing the surface area of the capacitor, and finally achieving the technical effect of increasing the capacitance of the capacitor.

In some embodiments, the capacitor includes a plurality of extension portions 31, and the plurality of extension portions 31 are distributed at least on one side of the body portion 32.

In some embodiments, the capacitor includes a plurality of extension portions 31, and the plurality of extension portions 31 are distributed on two opposite sides of the body portion 32 at least along a first direction D1. The first direction D1 is a direction parallel to a top surface of the substrate 10.

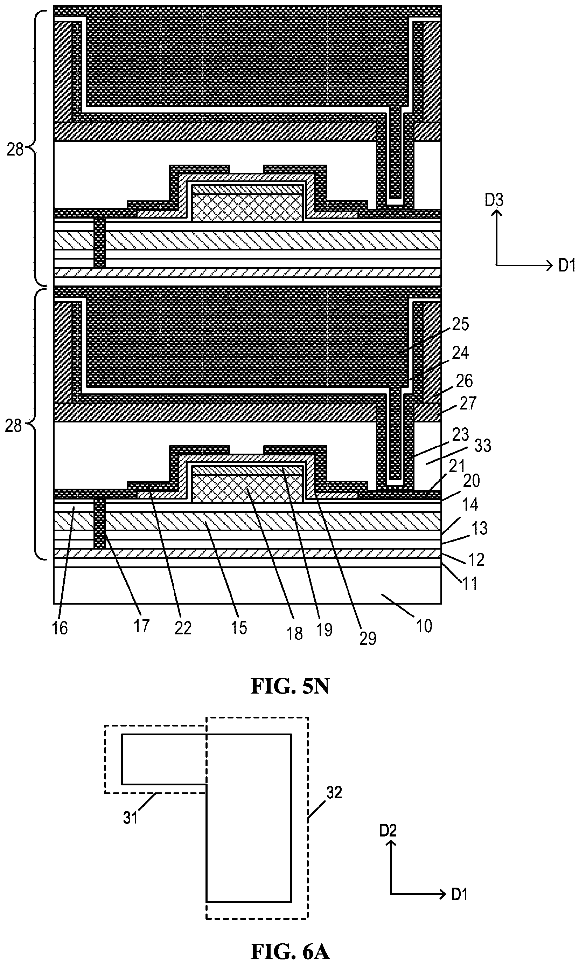

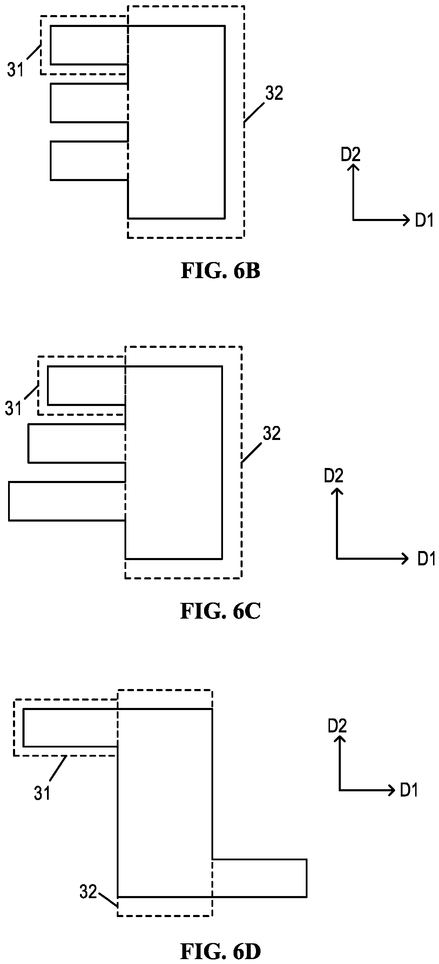

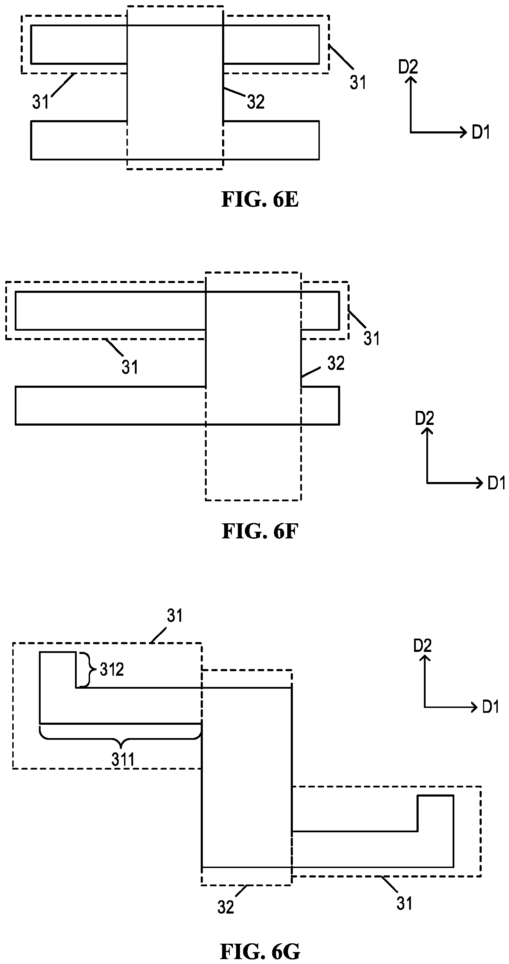

FIG. 6A to FIG. 6G are schematic views of various capacitors in a specific implementation of the present application. For example, as shown in FIG. 6A to FIG. 6C, there may be one extension portion 31, or there may be a plurality of extension portions 31. Said one extension portion 31 is located on one side of the body portion 32, and the plurality of extension portions 31 are located on the same side of the body portion 32. When there are a plurality of extension portions 31 and the plurality of extension portions 31 are located on the same side of the body portion 32 along the first direction D1, the lengths of the plurality of extension portions 31 along the first direction D1 may be the same with each other or different from each other, so that the capacitance of the capacitor may be flexibly set. The plurality in this specific implementation refers to two or more. As another example, as shown in FIG. 6D to FIG. 6G, there are a plurality of extension portions 31, and the plurality of extension portions 31 are distributed on two opposite sides of the body portion 32 along the first direction D1. In an embodiment, the lengths of the plurality of extension portions 31 located on two opposite sides of the body portion 32 along the first direction D1 may be the same with each other or different from each other to meet different requirements of the capacitance of the capacitor. In an embodiment, the plurality of extension portions 31 located on two opposite sides of the body portion 32 may be symmetrically distributed about the body portion or may not be symmetrically distributed about the body portion to make full use of the space in the semiconductor structure.

In an embodiment, each of the plurality of extension portions 31 may further include a first sub-portion 311, and a second sub-portion 312 located on a side surface of the first sub-portion 311 and electrically connected to the first sub-portion 311. The first sub-portion 311 is located on a side surface of the body portion 32 and electrically connected to the body portion 32, to further increase the surface area of the capacitor.

In order to further increase the surface area of the capacitor, in an embodiment, the first sub-lower electrode layer includes at least one corner. For example, the first sub-lower electrode layer has a surrounding frame shape.

The plurality of extension portions 31 are electrically connected to the body portion 32 such that the plurality of extension portions 31 and the body portion 32 in the capacitor are electrically connected to the same transistor. The extension direction of each of the plurality of extension portions 31 and the extension direction of the body portion 32 are not limited in this specific implementation, as long as the plurality of extension portions 31 intersect with the body portion 32 and are electrically connected to the body portion 32, thereby increasing the surface area of the capacitor. The intersection in this specific implementation may be a vertical intersection or an inclined intersection. In an embodiment, the plurality of extension portions 31 are in direct contact with the body portion 32 and are electrically connected to the body portion 32 to simplify the structure of the capacitor and reduce the manufacturing cost of the capacitor. The plurality in this specific implementation refers to two or more.

As shown in FIG. 1, in some embodiments, the transistor structure further includes:
source electrode/drain electrode, one of the source electrode/drain electrode being electrically connected to the capacitor;
a channel layer 29 located between the source electrode 22 and the drain electrode 21 of the source electrode/drain electrode; and
a gate electrode 18, the channel layer 29 surrounding at least a portion of the gate electrode 18.

Specifically, the plurality of memory cells 28 may be spaced apart from each other along a first direction D1 and along a second direction D2. The first direction D1 and the second direction D2 are directions parallel to the top surface of the substrate 10, and the second direction D2 and the first direction D1 intersect with each other. The transistor includes the gate electrode 18, a diffusion barrier layer 19 located above the gate electrode 18, a gate dielectric layer 20 covering a surface of the diffusion barrier layer 19 and a side wall of the gate electrode 18, the channel layer 29 located on a surface of the gate dielectric layer 20, and the source electrode 22 and the drain electrode 21 which are located on a surface of the channel layer 29. The channel layer 29 is continuously distributed above a plurality of gate electrodes 18 spaced apart from each other along the second direction D2, so that a plurality of transistors spaced apart from each other along the second direction D2 share the channel layer 29, thereby helping to simplify a manufacturing process of the semiconductor structure and a driving operation of the semiconductor structure. The material of the channel layer 29 may be an amorphous material. For example, the amorphous material may be any one or a combination of two or more oxide semiconductor materials such as indium gallium zinc oxide, IGZO, polysilicon, SnO₂, WO₃, In₂O₃, ZnO, TiO₂, Fe₂O₃, MoO₃, CuO, NiO, Co₃O₄, and Cr₂O₃. Each of the plurality of transistors includes the source electrode 22 and the drain electrode 21 spaced apart from each other along the first direction D1, the source electrodes 22 of the plurality of transistors are spaced apart from each other along the second direction D2, and the drain electrodes 21 of the plurality of transistors are also spaced apart from each other along the second direction D2. The source electrode/drain electrode described in this specific implementation refer to the source electrode and the drain electrode.

As shown in FIG. 1 and FIG. 2, in some embodiments, a width of a projection of the plurality of extension portions 31 on the substrate 10 along the first direction D1 is greater than a width of a projection of the body portion 32 on the substrate 10 along the first direction D1, and the body portion 32 is electrically connected to the transistor. For example, a projection of the body portion 32 on the top surface of the substrate 10 at least partially overlaps with a projection of the drain electrode 21 on the top surface of the substrate 10 such that the body portion 32 is in direct contact with the drain electrode 21 and is electrically connected to the drain electrode 21, thereby simplifying the manufacturing process of the semiconductor structure. Since the body portion 32 is in direct contact with the drain electrode 21 of the transistor and is electrically connected to the drain electrode 21 of the transistor, a depth of the body portion 32 along the third direction D3 is greater than a depth of each of the plurality of extension portions 31 along the third direction D3. An etching process of the body portion 32 may be simplified (for example, etching time is shortened) by making the width of the projection of the plurality of extension portions 31 on the substrate 10 along the first direction D1 to be greater than the width of the projection of the body portion 32 on the substrate 10 along the first direction D1.

In some embodiments, as shown in FIG. 1 and FIG. 2, the capacitor includes:
a lower electrode layer 23, including a first sub-lower electrode layer, and a second sub-lower electrode layer intersecting with the first sub-lower electrode layer, the lower electrode layer 23 being in contact with the transistor and being electrically connected to the transistor;
a dielectric layer 24 covering an inner surface of the lower electrode layer 23; and
an upper electrode layer 25 covering a surface of the dielectric layer 24.

The first sub-lower electrode layer defines a position of each of the plurality of extension portions, and the second sub-lower electrode layer defines a position of the body portion.

As shown in FIG. 1 and FIG. 2, in some embodiments, the transistor is located below the capacitor, and a first isolation layer 33 is arranged between the transistor and the capacitor. The body portion 32 of the capacitor penetrates through the first isolation layer 33 to be electrically connected to the transistor.

Specifically, as shown in FIG. 1 and FIG. 2, the first isolation layer 33 covers the transistor structure. The plurality of extension portions 31 are located above the first isolation layer 33, and the body portion 31 penetrates through the first isolation layer 33 along the third direction D3. A top end of the body portion 31 is in contact with the plurality of extension portions 31 and is electrically connected to the plurality of extension portions 31, and a bottom end of the body portion is in contact with the drain electrode 21 of the transistor and is electrically connected to the drain electrode 21 of the transistor. The material of the first isolation layer 33 may be an oxide material (for example, silicon dioxide).

In some embodiments, as shown in FIG. 1 and FIG. 2, the capacitor structure further includes:
a second isolation layer 55 located above the first isolation layer 33 and distributed between any two adjacent capacitors of the plurality of capacitors, the body portion 32 continuously penetrates through the first isolation layer 33 and the second isolation layer 55 along the third direction D3; and
a third isolation layer 26 located above the first isolation layer 33 and distributed around peripheries of the plurality of capacitors.

Specifically, as shown in FIG. 1 and FIG. 2, the capacitor structure further includes a fourth isolation layer 27 located between the second isolation layer 55 and the first isolation layer 33. The third isolation layer 26 is located on a surface of the fourth isolation layer 27 and is distributed around the peripheries of all the plurality of capacitors. The third isolation layer 26 serves, on the one hand, to isolate adjacent memory cells from each other, and serves, on the other hand, to support the capacitor structure, thereby improving the structural stability of the capacitor structure. Each of the plurality of extension portions 31 may include a first sub-lower electrode layer, a first sub-dielectric layer covering a surface of the first sub-lower electrode layer and a top surface of the second isolation layer 55, and a first sub-upper electrode layer covering a surface of the first sub-dielectric layer. The body portion 32 may include a second sub-lower electrode layer, a second sub-dielectric layer covering a surface of the second sub-lower electrode layer, and a second sub-upper electrode layer covering a surface of the second sub-dielectric layer. The first sub-lower electrode layer is in contact with the second sub-lower electrode layer and is electrically connected to the second sub-lower electrode layer. The first sub-lower electrode layer and the second sub-lower electrode layer collectively constitute the lower electrode layer 23 of the capacitor. The second sub-lower electrode layer is in contact with the drain electrode 21 of the transistor and is electrically connected to the drain electrode 21 of the transistor. The first sub-dielectric layer and the second sub-dielectric layer collectively constitute the dielectric layer 24 of the capacitor. The first sub-upper electrode layer and the second sub-upper electrode layer collectively constitute the upper electrode layer 25 of the capacitor.

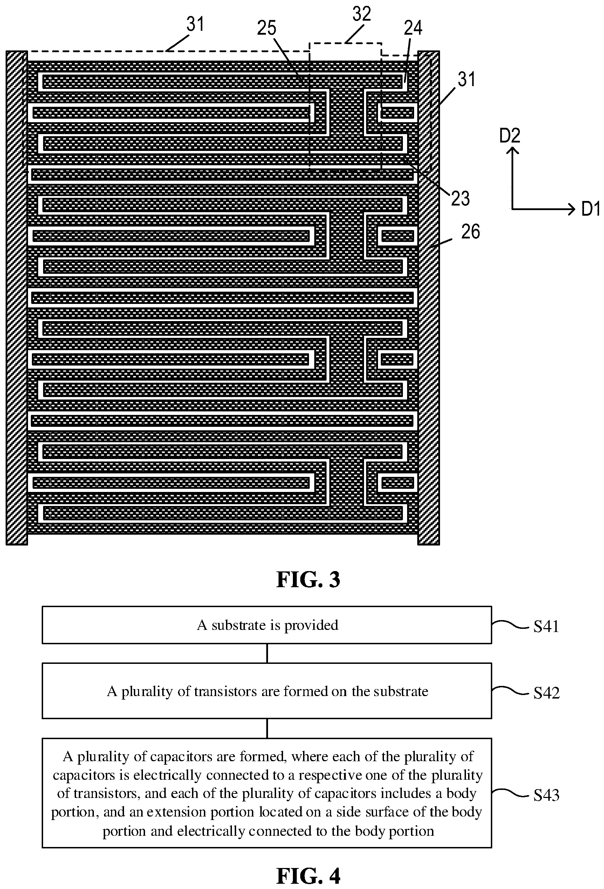

FIG. 3 is a schematic partial top view of a capacitor structure in another embodiment of a specific implementation of the present application. In another embodiment, the second isolation layer 55 may be absent in the semiconductor structure (as shown in FIG. 3), i.e., the dielectric layer 24 wraps the lower electrode layer 23, and the upper electrode layer 25 covers the entire surface of the dielectric layer 24, to further increase the capacitance of the capacitor. Specifically, as shown in FIG. 1 and FIG. 3, the capacitor includes:
a lower electrode layer 23, including a first sub-lower electrode layer, and a second sub-lower electrode layer intersecting with the first sub-lower electrode layer, the lower electrode layer 23 being in contact with the transistor and being electrically connected to the transistor;
a dielectric layer 24 continuously wrapping a surface of the lower electrode layer 23; and
an upper electrode layer 25 continuously wrapping a surface of the dielectric layer 24.

The first sub-lower electrode layer defines a position of the body portion 32, and the second sub-lower electrode layer defines a position of each of the plurality of extension portion 31. As shown in FIG. 1 and FIG. 3, in some embodiments, the plurality of memory cells 28 may be arranged in an array along a first direction D1 and a second direction D2, the first direction D1 and the second direction D2 are directions parallel to a top surface of the substrate 10, and the first direction D1 intersects with the second direction D2. The semiconductor structure further includes:
a plurality of word lines extending along the second direction D2, each of the plurality of word lines being electrically connected to respective ones of the plurality of memory cells 28 arranged in the second direction D2; and
a plurality of bit lines 12 extending along the first direction D1, the plurality of bit lines 12 being located below the plurality of word lines, and each of the plurality of bit lines 12 being electrically connected to respective ones of the plurality of memory cells 28 arranged in the first direction.

Specifically, the semiconductor structure includes the plurality of memory cells 28 spaced apart from each other along the second direction D2, and each of the plurality of transistors is located in a respective one of the plurality of memory cells 28. Each of the plurality of transistors includes a gate electrode 18, a source electrode and a drain electrode. The plurality of word lines extend along the second direction D2, and the plurality of word lines are in continuous contact with and are electrically connected to the gate electrodes 18 of the plurality of transistors in the plurality of memory cells 28. The plurality of bit lines 12 are located below the plurality of word lines and extend along the first direction D1 intersecting with the second direction D2. In an embodiment, the first direction D1 and the second direction D2 are both directions parallel to the top surface of the substrate 10.

In an embodiment, the plurality of bit lines 12 may be located in the substrate 10, i.e., each of the plurality of bit lines forms an embedded bit line structure. As shown in FIG. 1, in another embodiment, the plurality of bit lines 12 may be located above the substrate 10, thereby simplifying the manufacture process of the plurality of bit lines 12. In an example in which the plurality of bit lines 12 are located above the substrate 10, a substrate isolation layer 11 for isolating the substrate 10 from the plurality of bit lines 12 may be disposed between the plurality of bit lines 12 and the substrate 10. A fifth isolation layer may also be disposed between the plurality of bit lines 12 and the plurality of word lines. The fifth isolation layer may have a single-layer structure or a multi-layer structure. Each of the plurality of memory cells further includes a bit line contact plug 17. The bit line contact plug 17 penetrates through the fifth isolation layer along the third direction D3, one end of the bit line contact plug 17 of each of the plurality of memory cells is in contact with and electrically connected to the source electrode of a respective one of the plurality of transistors, and another end of said bit line contact plug 17 is in contact with and electrically connected to a respective one of the plurality of bit lines 12.

As shown in FIG. 1, in an embodiment, the fifth isolation layer includes a first dielectric layer 13 covering surfaces of the plurality of bit lines 12, a second dielectric layer 14 covering a surface of the first dielectric layer 13, a third dielectric layer 15 covering a surface of the second dielectric layer 14, and a fourth dielectric layer 16 covering a surface of the third dielectric layer 15. In an embodiment, the material of the first dielectric layer 13 may be an oxide material (for example, silicon dioxide), the material of the second dielectric layer 14 may be a nitride material (for example, silicon nitride), the material of the third dielectric layer 15 may be polyimide, and the material of the fourth dielectric layer 16 may be a nitride material (for example, silicon nitride). By disposing the fifth isolation layer with the multi-layer structure, the electrical isolation effect between the plurality of bit lines 12 and the plurality of word lines is enhanced while helping to further reduce the capacitive parasitic effect between the plurality of bit lines 12 and the plurality of word lines.

As shown in FIG. 1, in some embodiments, the plurality of memory cells 28 are stacked onto one another along a third direction D3. The third direction D3 is a direction perpendicular to the top surface of the substrate 10. Therefore, the semiconductor structure with a three-dimensional structure is formed, to further improve the integration and storage capacity of the semiconductor structure.

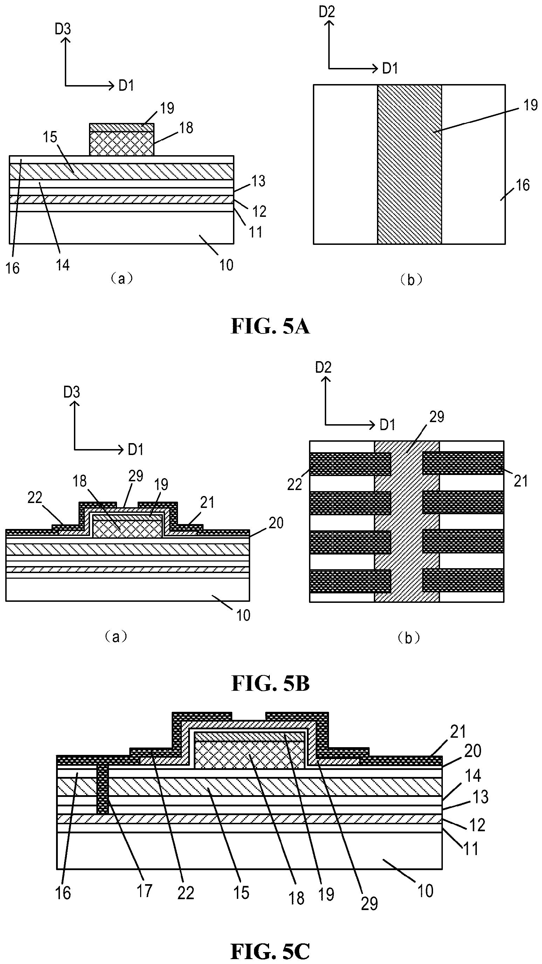

This specific implementation also provides a method for forming a semiconductor structure. FIG. 4 is a flowchart of a method for forming a semiconductor structure in a specific implementation of the present application. FIG. 5A to FIG. 5N are schematic views of main structures in a process of forming a semiconductor structure according to a specific implementation of the present application. A schematic view of the semiconductor structure formed by this specific implementation can be seen in FIG. 1 to FIG. 3. As shown in FIG. 1 to FIG. 4 and FIG. 5A to FIG. 5N, a method for forming a semiconductor structure includes the following operations. At S11, a substrate 10 is provided.

A plurality of memory cells are formed above the substrate. The operation that the plurality of memory cells are formed includes the following operations. At S12, a plurality of transistors are formed on the substrate 10. At S13, a plurality of capacitors are formed, where each of the plurality of capacitors is electrically connected to a respective one of the plurality of transistors, each of the plurality of capacitors includes a body portion 32, and an extension portion 31 located on a side surface of the body portion 32, and the extension portion 31 is electrically connected to the body portion 32.

In some embodiments, before the plurality of transistors are formed on the substrate 10, the method further includes the following operations.

A plurality of bit lines 12 spaced apart from each other along a second direction D2 are formed. Each of the plurality of bit lines 12 extends along a first direction D1, the first direction D1 and the second direction D2 are directions parallel to a top surface of the substrate 10, and the first direction D1 and the second direction D2 intersect with each other.

A fifth isolation layer covering the plurality of bit lines 12 is formed.

Specifically, as shown in FIG. 5A, an insulating dielectric material such as an oxide (for example, silicon dioxide) is deposited on the top surface of the substrate 10 and subjected to a planarization process such as chemical mechanical polishing to form a substrate isolation layer 11. Thereafter, the substrate isolation layer 11 is patterned, to form a plurality of bit line trenches extending along the first direction D1 in the substrate isolation layer 11, where the plurality of bit line trenches are spaced apart from each other along the second direction D2. The plurality of bit line trenches do not penetrate through the substrate isolation layer 11 along a third direction D3, where the third direction D3 is a direction perpendicular to the top surface of the substrate 10. Conductive materials such as tungsten metal are deposited in the plurality of bit line trenches to form the plurality of bit lines 12. Next, the fifth isolation layer covering the plurality of bit lines 12 is formed. The fifth isolation layer may include a single-layer or multi-layer structure. In an embodiment, the fifth isolation layer includes a first dielectric layer 13 covering surfaces of the plurality of bit lines 12, a second dielectric layer 14 covering a surface of the first dielectric layer 13, a third dielectric layer 15 covering a surface of the second dielectric layer 14, and a fourth dielectric layer 16 covering a surface of the third dielectric layer 15.

In some embodiments, the operation that the plurality of transistors are formed on the substrate 10 specifically includes the following operations.

A plurality of transistor areas spaced apart from each other along the second direction D2 are defined above the substrate 10.

A gate electrode 18 is formed in each of the plurality of transistor areas, and a word line extending along the second direction D2 is formed, where the word line is connected to the plurality of gate electrodes 18, as shown in FIG. 5A. The part (a) in FIG. 5A is a schematic cross-sectional view, and the part (b) in FIG. 5A is a top view.

A channel layer 29 extending along the second direction D1 is formed above word line, where the channel layer 29 continuously covers the plurality of transistor areas.

A source electrode 22 and a drain electrode 21 which cover at least a surface of the channel layer 29 are formed in each of the plurality of transistor areas, where the channel layer 29 is located at least between the source electrode 22 and the drain electrode 21, as shown in FIG. 5B. The part (a) in FIG. 5B is a schematic cross-sectional view, and the part (b) in FIG. 5B is a top view.

In some embodiments, the operation that the channel layer 29 extending along the second direction D1 is formed above the word line, where the channel layer 29 continuously covers the plurality of transistor areas specifically includes the following operations.

An amorphous material is deposited above the plurality of word lines to form the channel layer 29.

Specifically, a word line material (for example, tungsten metal) may be deposited above the fifth isolation layer. The word line material located in the plurality of transistor areas forms a plurality of gate electrodes 18 of the plurality of transistors, and the word line material between the plurality of gate electrodes 18 forms the plurality of word lines. Thereafter, a material such as TiN is deposited above the plurality of word lines and the plurality of gate electrode 18 to form a diffusion barrier layer 19, as shown in FIG. 5A, to prevent conductive particles in the plurality of gate electrodes 18 from diffusing outward. Thereafter, an oxide (for example, a dielectric material such as silicon dioxide and aluminum oxide) is deposited on a surface of the diffusion barrier layer 19, side walls of the plurality of gate electrodes 18, side walls of the plurality of word lines, and a surface of the fifth isolation layer to form the gate dielectric layer 20. An amorphous material such as IGZO is deposited on a surface of the gate dielectric layer 20 to form the channel layer 29. A source and drain metal material such as tungsten metal is deposited on a surface of the channel layer 29 and a surface of the gate dielectric layer 20 to form a plurality of source electrodes 22 and a plurality of drain electrodes 21, as shown in FIG. 5B.

In some embodiments, after a source electrode 22 and a drain electrode 21 covering at least a surface of the channel layer 29 is formed in each of the plurality of transistor areas, the method further includes the following operation.

A plurality of bit line contact plugs 17 at least penetrating through the fifth isolation layer are formed. One end of each of the plurality of bit line contact plugs 17 is electrically connected to a respective one of the plurality of bit lines 12, and another end of each of the plurality of bit line contact plugs 17 is electrically connected to a respective one of the plurality of source electrodes 22, as shown in FIG. 5C.

In some embodiments, the operation that the plurality of capacitors are formed includes the following operations.

A first isolation layer 33 covering the plurality of transistors is formed.

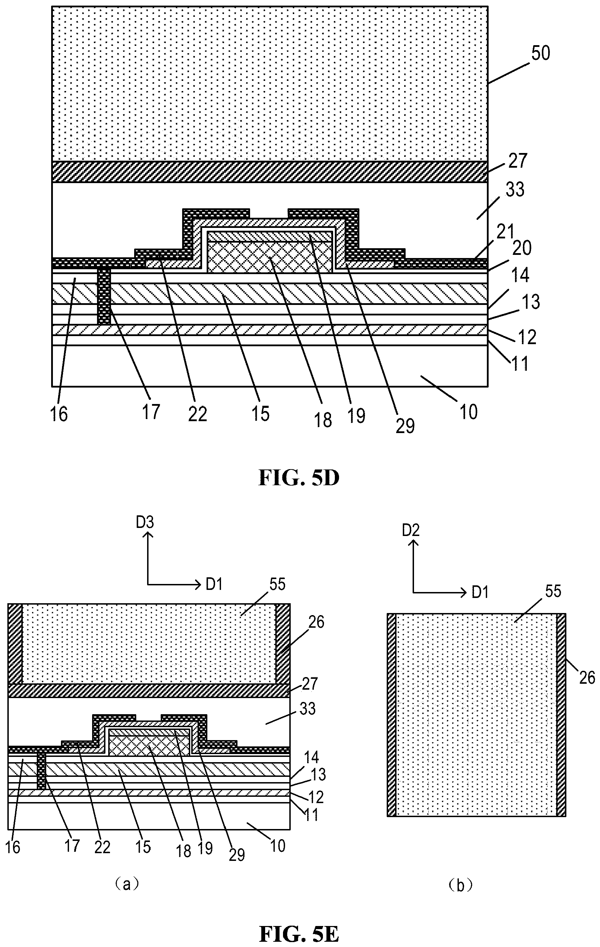

A second isolation layer 55 is formed above the first isolation layer 33, as shown in FIG. 5E. The part (a) in FIG. 5E is a schematic cross-sectional view, and the part (b) in FIG. 5E is a top view.

A plurality of capacitor areas spaced apart from each other along the second direction D2 is defined above the substrate 10, where the plurality of capacitors are formed in the plurality of capacitor areas are configured to form.

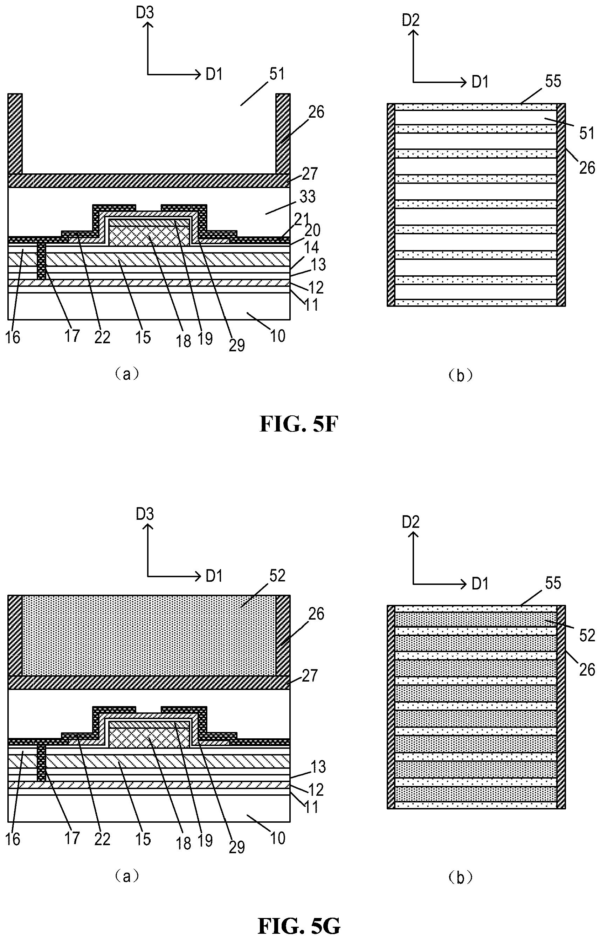

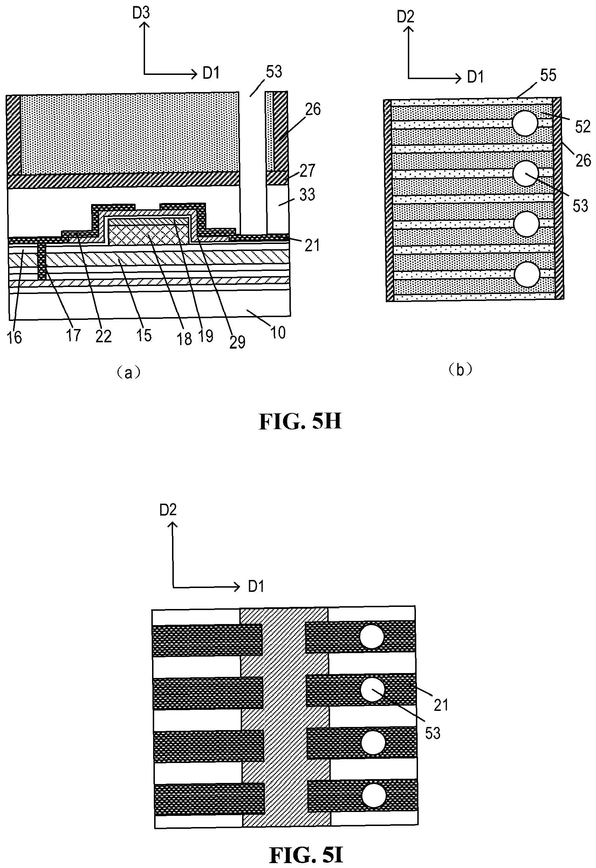

A plurality of sub-trenches 51 penetrating through the second isolation layer 55 along a third direction D3 (as shown in FIG. 5F, the part (a) in FIG. 5F is a schematic cross-sectional view, and the part (b) in FIG. 5F is a top view) and a plurality of communication trenches 53 penetrating through the second isolation layer 55 and the first isolation layer 33 along the third direction D3 are formed in each of the plurality of capacitor areas. Each of the plurality of communication trenches 53 in each of the plurality of capacitor areas communicates with the plurality of sub-trenches 51 in the same capacitor area. As shown in FIG. 5H, the part (a) in FIG. 5H is a schematic cross-sectional view, and the part (b) in FIG. 5H is a top view. The third direction D3 is a direction perpendicular to the top surface of the substrate 10.

A plurality of extension portions 31 are formed in the plurality of sub-trenches 51, and a plurality of body portions 32 are formed in the plurality of communication trenches 53.

In some embodiments, the operation that the second isolation layer 55 is formed above the first isolation layer 33 specifically includes the following operations.

A fourth isolation layer 27 covering the first isolation layer 33 is formed.

An initial second isolation layer 50 covering the fourth isolation layer 27 is formed, as shown in FIG. 5D.

The initial second isolation layer 50 is etched back, to form isolation trenches exposing the fourth isolation layer 27 at ends of the initial second isolation layer 50, where a remaining portion of the initial second isolation layer 50 serves as the second isolation layer 55, as shown in FIG. 5E.

A third isolation layer 26 is formed in the isolation trenches, as shown in FIG. 5E.

In some embodiments, the operation that the plurality of sub-trenches 51 penetrating through the second isolation layer 55 along the third direction D3 and the plurality of communication trenches 53 penetrating through the second isolation layer 55 and the first isolation layer 33 along the third direction D3 are formed specifically includes the following operations.

The second isolation layer 55 is etched along the first direction D1 to form a plurality of sub-trenches 51, where remaining portions of the second isolation layer 55 are spaced apart from each other along the second direction D2 by the plurality of sub-trenches 51.

The remaining portions of the second isolation layer 55 are selectively etched along the second direction D2 to form a plurality of communication trenches 53. Each of the plurality of communication trenches 53 communicates with at least two sub-trenches 51 of the plurality of sub-trenches 51. At this moment, the second isolation layer 55 is still present between adjacent sub-trenches 51 of the plurality of sub-trenches 51.

The fourth isolation layer 27 and the first isolation layer 33 are etched along the plurality of communication trenches 53 to expose the plurality of drain electrodes 21 of the plurality of transistors, thus forming a plurality of capacitor holes. In an embodiment of the present application, at least two sub-trenches 51 and a single communication trench 53 forms a single capacitor hole. Each of the plurality of capacitor holes may expose the drain electrode 21 of a single transistor, so that the surface area of a lower electrode subsequently deposited in each of the plurality of capacitor holes may be further increased while allows the lower electrode to be directly connected to a respective one of the plurality of transistors. Certainly, in other embodiments, instead of etching the fourth isolation layer 27 and the first isolation layer 33 along the plurality of communication trenches 53 to expose the plurality of drain electrodes 21 of the plurality of transistors, a capacitor lower electrode may be connected to the drain electrode 21 of each of the plurality of transistors by a capacitor contact plug structure.

Specifically, the second isolation layer 55 may be patterned using a photoetching process to form the plurality of sub-trenches 51 penetrating through the second isolation layer 55 along the third direction D3, as shown in FIG. 5F. Each of the capacitor areas at least includes two said sub-trenches 51. Next, a sacrificial layer 52 fully filling the plurality of sub-trenches 51 is formed, as shown in FIG. 5G. The part (a) in FIG. 5G is a schematic cross-sectional view, and the part (b) in FIG. 5G is a top view. Thereafter, the sacrificial layer 52 and part of the remaining portions of the second isolation layer 55 are etched to form the plurality of communication trenches 53 penetrating through the sacrificial layer 52 and the second isolation layer 55. Thereafter, the fourth isolation layer 27 and the first isolation layer 33 are etched downward along the plurality of communication trenches 53, to extend the plurality of communication trenches 53 to surfaces of the plurality of drain electrodes 51 of the plurality of transistors. Each of the plurality of communication trenches 53 in each of the plurality of capacitor areas at least intersects with two of the sub-trenches 51 located in the same capacitor area to form a respective one of the plurality of capacitor holes, as shown in FIG. 5H. In an embodiment, the bottoms of the plurality of communication trenches 53 expose the plurality of drain electrodes 21, as shown in FIG. 5I. FIG. 5I is a top view. The bottoms of the plurality of communication trenches 53 exposing the plurality of drain electrodes 21 means that a projection of each of the plurality of communication trenches 53 on the top surface of the substrate 10 at least partially overlaps with a projection of a respective one of the plurality of drain electrodes 21 of the plurality of transistors on the top surface of the substrate 10.

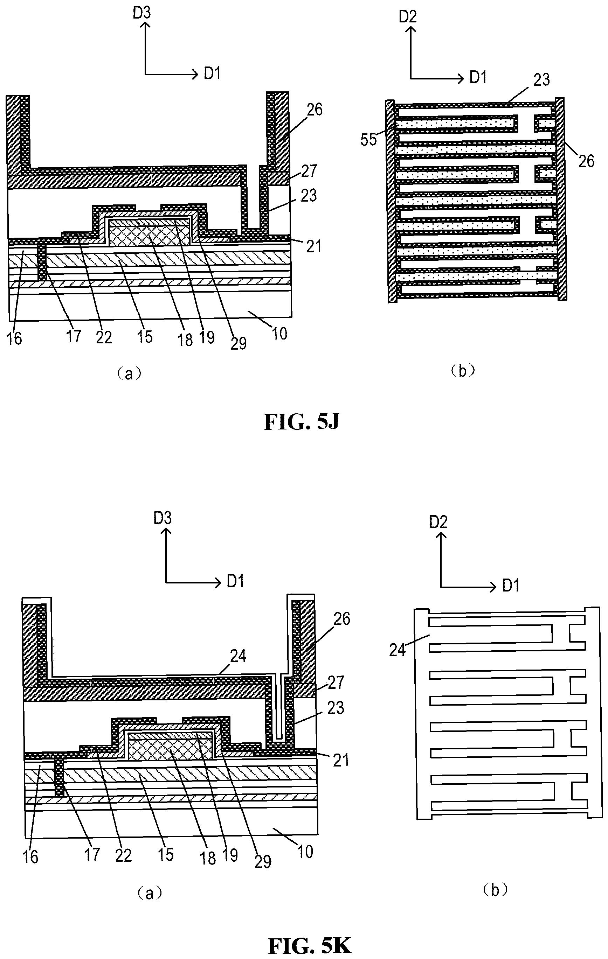

In some embodiments, as shown in FIG. 5K, FIG. 5M, FIG. 1 and FIG. 2, the operation that the plurality of extension portions 31 are formed in the plurality of sub-trenches 51 and the plurality of body portions 32 are formed in the plurality of communication trenches 53 specifically includes the following operations.

A lower electrode layer 23 continuously covering inner walls of the plurality of sub-trenches 51 and inner walls of the plurality of communication trenches 53 is formed, as shown in FIG. 5J. The part (a) in FIG. 5J is a schematic cross-sectional view, and the part (b) in FIG. 5J is a top view.

A dielectric layer 24 covering a surface of the lower electrode layer 23 and a top surface of the second isolation layer 55 is formed, as shown in FIG. 5K. The part (a) in FIG. 5K is a schematic cross-sectional view, and the part (b) in FIG. 5K is a top view.

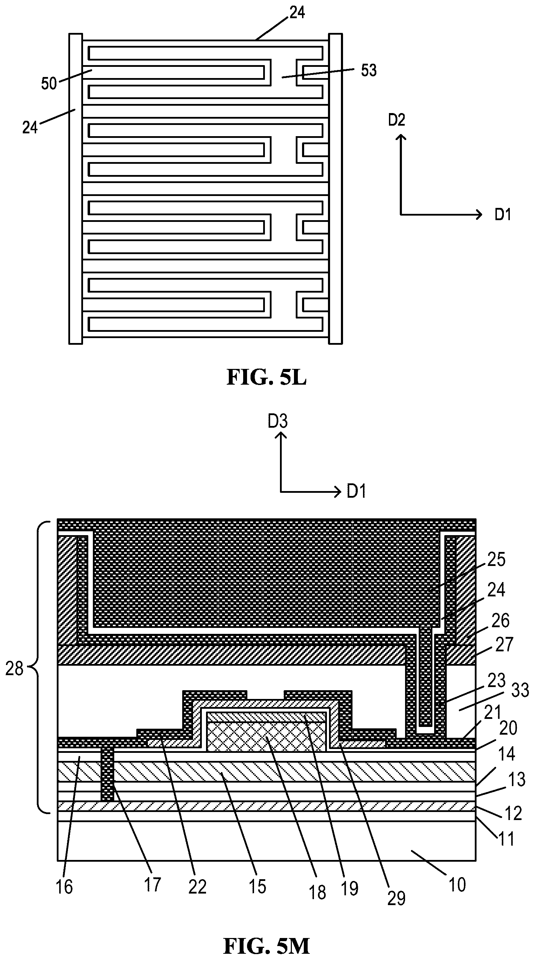

An upper electrode layer 25 covering a surface of the dielectric layer 24 is formed, as shown in FIG. 5M. The plurality of extension portions 31 include the lower electrode layer 23, the dielectric layer 24 and the upper electrode layer 25 which are located in the plurality of sub-trenches 51, and the plurality of body portions 32 include the lower electrode layer 23, the dielectric layer 54 and the upper electrode layer 25 which are located in the plurality of communication trenches 53. In this embodiment, at least two sub-trenches 51 and a single communication trench 53 forms a single capacitor hole. The lower electrode layer 23 is deposited in the capacitor hole, and adjacent lower electrode layers are independent from each other. When the dielectric layer 24 is formed on a surface of the lower electrode layer 23, the adjacent dielectric layers 24 are connected to each other, i.e., the dielectric layers 24 in the plurality of capacitors are shared by the plurality of capacitors. Thereafter, when the upper electrode layer 25 is formed on a surface of the dielectric layer 24, the adjacent upper electrode layers 25 are connected to each other, i.e., the upper electrode layers 25 in the plurality of capacitors are also shared by the plurality of capacitors.

Specifically, after the plurality of sub-trenches 51 and the plurality of communication trenches 53 are formed, the sacrificial layer 52 is removed, and a lower electrode material continuously covering the inner walls of the plurality of sub-trenches 51 and the inner walls of the plurality of communication trenches 53 is deposited. The lower electrode material located on the inner walls of the plurality of sub-trenches 51 serves as a first sub-lower electrode layer, the lower electrode material located on the inner walls of the plurality of communication trenches 53 serves as a second sub-lower electrode layer, and the first sub-lower electrode layer and the second sub-lower electrode layer serve as the lower electrode layer 23. Thereafter, the dielectric layer 24 continuously covering the surface of the lower electrode layer 23 and the top surface of the second isolation layer 55 is deposited, and the upper electrode layer 25 covering the surface of the dielectric layer 24 is deposited. The plurality of extension portions 31 include the lower electrode layer 23, the dielectric layer 24 and the upper electrode layer 25 which are located in the sub-trench 51, the plurality of body portions 32 include the lower electrode layer 23, the dielectric layer 54 and the upper electrode layer 25 which are located in the plurality of communication trenches 53, and the layers in the plurality of extension portions 31 (including the lower electrode layer 23, the dielectric layer 24 and the upper electrode layer 25) and the layers in the plurality of body portions 32 (including the lower electrode layer 23, the dielectric layer 24 and the upper electrode layer 25) are deposited and formed synchronously. Therefore, the internal resistance of the capacitor can be reduced while simplifying the manufacturing process of the semiconductor structure.

In other embodiments, as shown in FIG. 5L to FIG. 5M, FIG. 1 and FIG. 3, the operation that the plurality of extension portions 31 are formed in the plurality of sub-trenches 51 and the plurality of body portions 32 are formed in the plurality of communication trenches 53 specifically includes the following operations.

A lower electrode layer 23 continuously covering inner walls of the plurality of sub-trenches 51 and inner walls of the plurality of communication trenches 53 is formed.

The second isolation layer 55 is removed.

A dielectric layer 24 covering a surface of the lower electrode layer 23 is formed, as shown in FIG. 5L.

An upper electrode layer 25 covering a surface of the dielectric layer 24 is formed. The lower electrode layer 23, the dielectric layer 24 and the upper electrode layer 25 which are located in the plurality of sub-trenches 51 constitute the plurality of extension portions 31, and the lower electrode layer 23, the dielectric layer 24 and the upper electrode layer 25 which are located in the plurality of communication trenches 53 constitute the plurality of body portions 32.

Specifically, after the lower electrode layer 23 is formed, the second isolation layer 55 may be removed, such that the subsequently formed dielectric layer 24 wraps the lower electrode layer 23, thereby further increasing the surface area of each of the plurality of capacitors and increasing the capacitance of each of the plurality of capacitors.

In some embodiments, the method for forming the semiconductor structure further includes the following operation.

The plurality of memory cells 28 stacked onto one another along a third direction D3 are successively formed above the substrate 10. The third direction D3 is a direction perpendicular to the top surface of the substrate 10, as shown in FIG. 5N.

Some embodiments of this specific implementation provide a semiconductor structure and a method for forming a semiconductor structure. A capacitor structure is disposed above a transistor structure, and the capacitor structure includes a plurality of capacitors. Each of the plurality of capacitors includes an extension portion and a body portion intersecting with the extension, which may increase the dimension of the plurality of capacitors is increased, thereby increasing the capacitance of each of the plurality of capacitors to increase the storage capacity of the semiconductor structure. In addition, each of the plurality of capacitors including the extension portion and the body portion in this specific implementation is located above the transistor structure, so that a three-dimensional space above the substrate can be fully utilized, the occupation of the surface area of the substrate can be reduced, and the space utilization rate inside the semiconductor structure can be improved, thereby contributing to further controlling the dimension of the semiconductor structure and expanding the application field of the semiconductor structure. In the embodiments of this specific implementation, the dimension of a single layer can be increased, and multi-layer stacking of three-dimensional semiconductor structures can also be achieved, thereby reducing the process difficulty and increasing the storage density of the semiconductor structure.

The above is a preferred implementation of the present application. It is to be noted that a number of modifications and refinements may be made by those of ordinary skill in the art without departing from the principles of the present application, and such modifications and refinements are also considered to be within the scope of protection of the present application.

## Claims

1. A semiconductor structure, comprising a plurality of memory cells located on a substrate, each of the plurality of memory cells comprising:
a transistor; and
a capacitor electrically connected to the transistor, wherein the capacitor comprises a body portion, and at least one extension portion located on a side surface of the body portion, and the at least one extension portion is electrically connected to the body portion.

2. The semiconductor structure of claim 1, wherein the capacitor comprises a plurality of extension portions, and the plurality of extension portions are distributed at least on one side of the body portion.

3. The semiconductor structure of claim 1, wherein the capacitor comprises a plurality of extension portions, and the plurality of extension portions are distributed on two opposite sides of the body portion at least along a first direction, wherein the first direction is a direction parallel to a top surface of the substrate.

4. The semiconductor structure of claim 1, wherein the transistor comprises:
source electrode/drain electrode, one of the source electrode/drain electrode being electrically connected to the capacitor;
a channel layer located between the source electrode and the drain electrode of the source electrode/drain electrode; and
a gate electrode, the channel layer surrounding at least a portion of the gate electrode.

5. The semiconductor structure of any one of claims 1 to 4, wherein a width of a projection of the extension portion on the substrate along a first direction is greater than a width of a projection of the body portion on the substrate along the first direction, and the body portion is electrically connected to the transistor.

6. The semiconductor structure of claim 1 or 5, wherein the capacitor comprises:
a lower electrode layer, comprising a first sub-lower electrode layer, and a second sub-lower electrode layer intersecting with the first sub-lower electrode layer, the lower electrode layer being in contact with the transistor and being electrically connected to the transistor;
a dielectric layer covering an inner surface of the lower electrode layer; and
an upper electrode layer covering a surface of the dielectric layer,
wherein the first sub-lower electrode layer defines a position of the body portion, and the second sub-lower electrode layer defines a position of the extension portion.

7. The semiconductor structure of claim 1 or 5, wherein the capacitor comprises:
a lower electrode layer, comprising a first sub-lower electrode layer, and a second sub-lower electrode layer intersecting with the first sub-lower electrode layer, the lower electrode layer being in contact with the transistor and being electrically connected to the transistor;
a dielectric layer continuously wrapping a surface of the lower electrode layer; and
an upper electrode layer continuously wrapping a surface of the dielectric layer,
wherein the first sub-lower electrode layer defines a position of the body portion, and the second sub-lower electrode layer defines a position of the extension portion.

8. The semiconductor structure of claim 1, wherein the transistor is located below the capacitor, and a first isolation layer is arranged between the transistor and the capacitor, wherein the body portion of the capacitor penetrates through the first isolation layer to be electrically connected to the transistor.

9. The semiconductor structure of claim 1, wherein the plurality of memory cells are arranged in an array along a first direction and a second direction, the first direction and the second direction are directions parallel to a top surface of the substrate, and the first direction intersects with the second direction; the semiconductor structure further comprises:
a plurality of word lines extending along the second direction, each of the plurality of word lines being electrically connected to respective ones of the plurality of memory cells arranged in the second direction; and
a plurality of bit lines extending along the first direction, the plurality of bit lines being located below the plurality of word lines, and each of the plurality of bit lines being electrically connected to respective ones of the plurality of memory cells arranged in the first direction.

10. The semiconductor structure of claim 1 or 9, wherein the plurality of memory cells are stacked onto one another along a third direction, wherein the third direction is a direction perpendicular to a top surface of the substrate.

11. A method for forming a semiconductor structure, comprising:
providing a substrate;
forming a plurality of memory cells on the substrate, wherein forming the plurality of memory cells comprising:
forming a plurality of transistors on the substrate; and
forming a plurality of capacitors, wherein each of the plurality of capacitors is electrically connected to a respective one of the plurality of transistors, each of the plurality of capacitors comprises a body portion, and an extension portion located on a side surface of the body portion, and the extension portion is electrically connected to the body portion.

12. The method for forming the semiconductor structure of claim 11, wherein before forming the plurality of transistors on the substrate, the method further comprises:
forming a plurality of bit lines spaced apart from each other along a second direction, wherein each of the plurality of bit lines extends along a first direction, the first direction and the second direction are directions parallel to a top surface of the substrate, and the first direction and the second direction intersect with each other; and
forming a third isolation layer covering the plurality of bit lines.

13. The method for forming the semiconductor structure of claim 12, wherein forming the plurality of transistors on the substrate comprises:
defining, above the substrate, a plurality of transistor areas spaced apart from each other along the second direction;
forming a gate electrode in each of the plurality of transistor areas, and forming a word line extending along the second direction, the word line being connected to the plurality of gate electrodes;
forming, above the word line, a channel layer extending along the second direction, the channel layer continuously covering the plurality of transistor areas; and
forming, in each of the plurality of transistor areas, a source electrode and a drain electrode which cover at least a surface of the channel layer, wherein the channel layer is located at least between the source electrode and the drain electrode.

14. The method for forming the semiconductor structure of claim 12 or 13, wherein forming the plurality of capacitors comprises:
forming a first isolation layer covering the plurality of transistors;
forming a second isolation layer above the first isolation layer;
defining, above the substrate, a plurality of capacitor areas spaced apart from each other along the second direction, wherein the plurality of capacitors are formed in the plurality of capacitor areas;
forming, in each of the plurality of capacitor areas, a plurality of sub-trenches and a plurality of communication trenches, wherein the plurality of sub-trenches penetrate through the second isolation layer along a third direction, and the plurality of communication trenches penetrate through the second isolation layer and the first isolation layer along the third direction, wherein each of the plurality of communication trenches in each of the plurality of capacitor areas communicates with the plurality of sub-trenches in the same capacitor area, and the third direction is a direction perpendicular to the top surface of the substrate; and
forming the extension portion in each of the plurality of sub-trenches and forming the body portion in each of the plurality of communication trenches.

15. The method for forming the semiconductor structure of claim 14, wherein forming the extension portion in each of the plurality of sub-trenches and forming the body portion in each of the plurality of communication trenches comprises:
forming a lower electrode layer continuously covering inner walls of the plurality of sub-trenches and inner walls of the plurality of communication trenches;
forming a dielectric layer covering a surface of the lower electrode layer and a top surface of the second isolation layer; and
forming an upper electrode layer covering a surface of the dielectric layer, wherein the extension portion comprises the lower electrode layer, the dielectric layer and the upper electrode layer which are located in each of the plurality of sub-trenches, and the body portion comprises the lower electrode layer, the dielectric layer and the upper electrode layer which are located in each of the plurality of communication trenches.

16. The method for forming the semiconductor structure of claim 14, wherein forming the extension portion in each of the plurality of sub-trenches and forming the body portion in each of the plurality of communication trenches comprises:
forming a lower electrode layer continuously covering inner walls of the plurality of sub-trenches and inner walls of the plurality of communication trenches;
removing the second isolation layer;
forming a dielectric layer covering a surface of the lower electrode layer; and
forming an upper electrode layer covering a surface of the dielectric layer, wherein the lower electrode layer, the dielectric layer and the upper electrode layer which are located in each of the plurality of sub-trenches constitute the extension portion, and the lower electrode layer, the dielectric layer and the upper electrode layer which are located in each of the plurality of communication trenches constitute the body portion.

17. The method for forming the semiconductor structure of any one of claims 11 to 16, further comprising:
successively forming the plurality of memory cells stacked onto one another along a third direction above the substrate, wherein the third direction is a direction perpendicular to a top surface of the substrate.
